# FASCICULE DE BREVET EUROPEEN

(11) **EP 2 732 469 B1**
(45) Date de publication et mention de la délivrance du brevet: **30.08.2017**
(21) Numéro de dépôt: 12733684.0
(22) Date de dépôt: 05.07.2012
(51) Int. Cl.: H01L 27/16, H01L 35/32, H01L 23/38

(54) **PROCÉDÉ DE GÉNÉRATION D'ÉNERGIE ÉLECTRIQUE AU SEIN D'UNE STRUCTURE INTÉGRÉE TRIDIMENSIONNELLE, ET DISPOSITIF DE LIAISON CORRESPONDANT**
VERFAHREN ZUR ERZEUGUNG VON ENERGIE IN EINER INTEGRIERTEN DREIDIMENSIONALEN STRUKTUR, UND ENTSPRECHENDE VERBINDUNGSVORRICHTUNG
METHOD FOR GENERATING POWER WITHIN AN INTEGRATED THREE-DIMENSIONAL STRUCTURE, AND CORRESPONDING CONNECTION DEVICE

(30) Priorité: 13.07.2011 FR 1156420
(43) Date de publication de la demande: 21.05.2014
(73) Titulaire: STMicroelectronics (Rousset) SAS, 13790 Rousset (FR)
(72) Inventeur: FORNARA, Pascal, F-83910 Pourrières (FR); RIVERO, Christian, F-13790Rousset (FR)
(74) Mandataire: Casalonga, Axel
(86) Numéro de dépôt international: PCT/EP2012/063129
(87) Numéro de publication internationale: WO 2013/007593

(56) Documents cités:
- WO-A2-2010/010520
- FR-A1- 2 946 460
- US-A1- 2005 077 619
- US-A1- 2006 102 223
- US-A1- 2009 000 652
- US-A1- 2010 219 525

## Description

L'invention concerne la microélectronique, notamment les plateformes technologiques tridimensionnelles, et plus particulièrement la génération d'énergie électrique dans une structure intégrée autre que celle produite par une alimentation classique comme par exemple une batterie.

Une structure intégrée tridimensionnelle comprend par exemple plusieurs éléments (au moins deux) électriquement interconnectés par un dispositif de liaison, ou « interposeur » généralement connu par l'homme du métier sous la dénomination anglosaxonne « interposer ». Généralement l'interposeur comprend par exemple un substrat de silicium pouvant être surmonté de pistes métalliques s'étendant sur au moins un niveau de métallisation et/ou être équipé de vias traversants, communément désignés par l'homme du métier sous l'acronyme anglosaxon TSV (Through Silicon Via), de façon à assurer l'interconnexion entre différents éléments pouvant être disposés sur une même face ou sur des faces différentes de l'interposeur. FR 2 946 460 A1 (ST MICROELECTRONICS ROUSSET [FR]) 10 décembre 2010 divulgue un circuit intégré, comprenant au moins une région contenant au moins un matériau thermoélectrique et configurée pour être soumise à au moins un gradient de température résultant d'une circulation d'un courant électrique dans moins une partie du circuit intégré lors de son fonctionnement, et des moyens de sortie électriquement conducteurs couplés à ladite ou auxdites régions pour délivrer l'énergie électrique produite par le ou les matériaux thermoélectriques. US 2005/077619 A1 (RAMANATHAN SHRIRAM [US] ET AL) 14 avril 2005 divulgue un assemblage microélectronique comportant des éléments thermoélectriques pour refroidir un substrat sémiconducteur. US 2010/219525 A1 (IBARAKI SOICHIRO [JP]) 2 septembre 2010 divulgue un interposeur ayant une pluralité de vias s'étendant de la première surface à la seconde surface. Un semiconducteur de type N et un semiconducteur de type P constituant un élément Peltier sont prévus dans chacun des deux vias. Ainsi deux éléments, tels que des circuits intégrés peuvent être connectés sur une même première face de l'interposeur par l'intermédiaire de billes ou « bumps », tout en étant électriquement interconnectés ou non, et un autre élément, par exemple une carte de circuit imprimé (PCB : Printed Circuit Board), ou bien un autre circuit intégré, peut être électriquement relié à l'autre face de l'interposeur par l'intermédiaire également de billes ou « bumps ».

Selon un mode de mise en oeuvre et de réalisation, il est ainsi proposé de récupérer de l'énergie électrique à partir du fonctionnement propre de la structure intégrée, pour éventuellement stocker cette énergie électrique afin de pouvoir par exemple alimenter une partie spécifique d'un circuit intégré de la structure et/ou recharger une batterie. Il devient alors possible d'augmenter considérablement la durée de vie de la batterie et/ou de diminuer la taille de celle-ci.

A cet égard il est proposé en particulier d'utiliser la place disponible dans l'interposeur de la structure pour y loger un générateur thermoélectrique qui va permettre de générer cette énergie électrique.

En effet lorsque l'interposeur comprend un substrat semiconducteur et, au dessus du substrat, une partie d'interconnexion électriquement conductrice noyée dans un enrobage isolant, communément désignée par l'homme du métier sous l'acronyme anglosaxon BEOL (« Back End Of Lines ») et servant à l'interconnexion entre divers éléments de la structure intégrée avec les pistes métalliques contenues dans cette partie d'interconnexion (BEOL), il est particulièrement aisé qu'une partie au moins des thermocouples, en particulier des couples de barreaux N et P, soit noyée au sein de l'enrobage isolant entre ladite partie d'interconnexion et le substrat semiconducteur.

Les liaisons électriques entre les différents thermocouples peuvent alors être aisément réalisées sur au moins un niveau de métallisation de la partie d'interconnexion.

Un générateur thermoélectrique logé dans l'interposeur est avantageusement mais non limitativement un générateur réalisé en technologie CMOS et en particulier totalement compatible avec des technologies de fabrication déjà largement utilisées dans le domaine de la microélectronique, en particulier pour la fabrication de mémoires non volatiles embarquées (« Embedded Memory ») selon la dénomination bien connue de l'homme du métier, c'est-à-dire des mémoires qui sont réalisées sur le même circuit intégré que celui contenant un autre composant, par exemple un processeur, par opposition aux modules de mémoires externes qui sont réalisés sur un circuit intégré spécifique externe et différent de celui contenant un processeur.

Il est en particulier proposé d'utiliser des couches de matériau, par exemple de polysilicium, déjà disponibles pour réaliser les cellules-mémoire et sans que le générateur ne nécessite l'adjonction de masques supplémentaires ou d'étapes de procédé supplémentaires par rapport aux procédés de fabrication de cellules-mémoire existants.

En variante, il est proposé d'utiliser un générateur dont le procédé de réalisation tout en s'intégrant dans un procédé classique de fabrication de cellules-mémoire, nécessite néanmoins l'adjonction de quelques étapes de procédé supplémentaires, particulièrement simples à mettre en oeuvre.

Selon un aspect il est proposé un procédé de génération d'énergie électrique au sein d'une structure intégrée tridimensionnelle comprenant plusieurs éléments électriquement interconnectés par un dispositif de liaison, le procédé comprenant une production d'un gradient de température dans au moins une région du dispositif de liaison résultant du fonctionnement d'au moins un desdits éléments, et une production d'énergie électrique à partir d'au moins un générateur thermoélectrique comportant au moins un ensemble de thermocouples électriquement connectés en série et thermiquement connectés en parallèle et contenus dans ladite région soumise audit gradient de température.

Selon un autre aspect il est proposé un dispositif de liaison pour l'interconnexion de plusieurs éléments d'une structure intégrée tridimensionnelle, comprenant en outre au moins un générateur thermoélectrique comportant au moins un ensemble de thermocouples électriquement connectés en série et thermiquement connectés en parallèle.

Selon un mode de réalisation avantageux, compatible notamment avec des technologies de fabrication de mémoires non volatiles embarquées, le dispositif de liaison comprend un substrat semiconducteur, par exemple en silicium, et des régions isolantes, par exemple des tranchées peu profondes connues par l'homme du métier sous la dénomination anglosaxonne STI (Shallow Trench Isolation), et ledit au moins un ensemble de thermocouples comprend des régions semiconductrices parallèles, par exemple des régions de polysilicium dopées N ou P, ayant chacune un type de conductivité pris parmi deux types de conductivité opposés ;
certaines au moins de ces régions semiconductrices parallèles peuvent s'étendre dans le substrat entre des régions isolantes parallèles,
ou bien certaines au moins de ces régions semiconductrices parallèles peuvent s'étendre à cheval au dessus d'une partie du substrat en étant électriquement isolées de ladite partie de substrat, et au dessus d'au moins une partie des régions isolantes,
ou bien certaines au moins de ces régions semiconductrices parallèles sont enrobées d'un matériau isolant et peuvent s'étendre intégralement au dessus de régions isolantes parallèles, ou intégralement au dessus des régions de substrat situées entre lesdites régions isolantes parallèles.

Quelle que soit la configuration, lesdites régions semiconductrices sont électriquement reliées en série de façon à former une chaîne de régions ayant alternativement l'un et l'autre des deux types de conductivité.

Selon un mode de réalisation, le générateur comprend également des moyens de connexion électriquement conducteurs assurant la liaison électrique entre les régions semiconductrices, ces moyens de connexion étant situés au dessus du substrat et reliant une zone d'extrémité d'une région semiconductrice ayant l'un des deux types de conductivité, par exemple le type de conductivité N, à une zone d'extrémité d'une région semiconductrice ayant l'autre type de conductivité, par exemple le type de conductivité P.

Par exemple, les moyens de connexion sont enrobés dans un matériau isolant et comprennent des pistes métalliques parallèles aux régions semiconductrices connectées auxdites zones d'extrémité par des liaisons électriques verticales, connues par l'homme du métier sous la dénomination de « vias » ou « contacts ».

Plusieurs structures sont possibles pour la réalisation de l'ensemble de thermocouples.

Il est également possible que le générateur comprenne au moins un autre ensemble de thermocouples électriquement connectés en série et thermiquement connectés en parallèle, tous les ensembles étant mutuellement électriquement et thermiquement connectés en parallèle.

Selon un autre aspect, il est également proposé une structure intégrée tridimensionnelle, comprenant au moins deux éléments électriquement interconnectés par un dispositif de liaison tel que défini ci-avant, dont le générateur thermoélectrique est en couplage thermique avec l'un au moins desdits éléments de façon à ce que ledit un au moins desdits éléments soit apte en fonctionnement à générer un gradient de température entre les premières zones d'extrémités homologues et les deuxièmes zones d'extrémités homologues de tous les thermocouples, le dispositif de liaison comprenant en outre des moyens de sortie électriquement conducteurs couplés audit générateur pour délivrer l'énergie électrique produite par ledit générateur.

Il est également possible que la structure intégrée comprenne des moyens de stockage d'énergie électrique, électriquement couplés aux moyens de sortie électriquement conducteurs.

Selon un mode de réalisation le dispositif de liaison comprend au moins un niveau de métallisation au dessus d'un substrat semiconducteur et au moins une partie des liaisons électriques entre les thermocouples comporte des pistes métalliques s'étendant sur au moins un niveau de métallisation.

D'autres avantages et caractéristiques de l'invention apparaîtront à l'examen de la description détaillée de modes de réalisation, nullement limitatifs, et des dessins annexés, sur lesquels :
- la figure 1 illustre schématiquement un mode de mise en oeuvre d'un procédé au sein d'un mode de réalisation d'un dispositif de liaison ou interposeur d'un exemple de structure intégrée selon l'invention incorporant un exemple de générateur thermoélectrique,
- les figures 2 et 3 illustrent schématiquement des exemple de générateurs pouvant être supportés et/ou incorporés dans un dispositif de liaison selon l'invention, et
- les figures 4 à 16 illustrent plus en détail mais toujours de façon schématique, d'autres exemples de générateurs pouvant être supportés et/ou incorporés dans un dispositif de liaison selon l'invention.

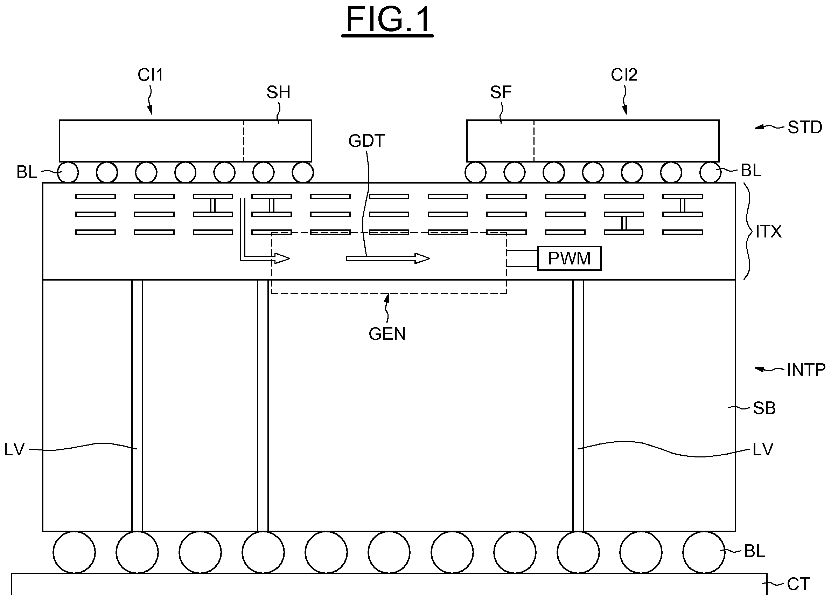

Sur la figure 1, la référence STD désigne une structure intégrée tridimensionnelle, comportant un dispositif de liaison ou interposeur INTP sur la face supérieure duquel sont connectés dans cet exemple deux circuits intégrés CI1 et CI2, par exemple par l'intermédiaire de billes de connexion BL (« bumps »).

Par ailleurs, la structure intégrée STD comporte également un troisième élément, à savoir en l'espèce une carte de circuit intégré (« Printed Circuit Board » : PCB) sur laquelle est connectée la face inférieure de l'interposeur INTP également par l'intermédiaire de billes de connexion BL.

L'interposeur INTP comporte un substrat SB, généralement en silicium, ainsi qu'une partie d'interconnexion ITX comportant plusieurs niveaux de métallisation, au sein desquels sont réalisés des pistes métalliques reliées entre elles pour certaines d'entre elles par des vias. L'ensemble des pistes métalliques et de vias est enrobé dans un enrobage isolant, par exemple du dioxyde de silicium, et permet d'assurer, en particulier, l'interconnexion électrique entre les deux circuits intégrés CI1 et CI2.

Le substrat SB comporte également des liaisons verticales LV électriquement conductrices, réalisées sous la forme de TSV (« Through Silicon Vias ») et permettant de relier électriquement, par exemple, certaines des pistes métalliques de la partie d'interconnexion ITX avec les billes BL de façon à assurer une connexion électrique verticale entre l'un au moins des circuits intégrés CI1 et CI2 avec la carte CT.

Il est proposé ici, selon un aspect de l'invention, d'utiliser l'interposeur INTP pour y incorporer un générateur thermoélectrique GEN.

Les générateurs thermoélectriques comprennent, de façon classique, un ensemble de thermocouples électriquement connectés en série et thermiquement connectés en parallèle. Des thermocouples thermiquement connectés en parallèle s'entendent comme étant des thermocouples destinés à être tous soumis à un même gradient de température, par exemple lorsqu'une source de chaleur est disposée à une des extrémités des thermocouples, et lorsqu'une source froide est disposée à l'autre extrémité.

Il se crée alors aux deux bornes de l'ensemble des thermocouples reliés électriquement en série, une différence de potentiel qui est due à l'effet Seebeck.

Selon un aspect de l'invention, l'activité électrique des différents circuits intégrés CI1, CI2 connectés sur l'interposeur INTP, va générer un gradient de température GDT auquel va être soumis le générateur GEN.

En effet, les circuits intégrés n'ont pas nécessairement la même activité au même moment. Ainsi, comme illustré sur la figure 1, une extrémité du générateur GEN est en couplage thermique avec une partie du circuit intégré CI1 qui forme une source chaude, tandis que l'autre extrémité du générateur GEN est en couplage thermique avec une partie de l'autre circuit intégré CI2 qui forme une source froide. Bien entendu, l'opération est réversible, c'est-à-dire que la source froide peut devenir à un moment donné la source chaude, et la source chaude peut devenir la source froide. Dans ce cas, le gradient de température est inversé ainsi que le sens du courant généré.

Il serait également possible, si la structure STD ne comporte qu'un seul circuit intégré, par exemple le circuit CI1, de placer une extrémité du générateur GEN en couplage thermique avec ce circuit intégré CI1 formant alors la source chaude SH, tandis que l'autre extrémité du générateur GEN ne serait en couplage thermique avec aucun circuit intégré, ce qui constituerait alors une source froide.

L'énergie électrique délivrée aux bornes du générateur GEN peut être alors gérée par un module de gestion d'énergie PWM qui peut être un composant spécifique directement réalisé sur l'interposeur et même mieux, être un module embarqué, c'est-à-dire réalisé en même temps que le générateur GEN.

Ce module PWM peut alimenter directement une charge, ou bien une batterie, ou encore des moyens de stockage tels qu'un condensateur.

D'une façon générale, toute structure de générateur thermoélectrique convient.

On peut notamment utiliser les générateurs décrits dans les publications suivantes :
l'article de Vullers et autres, intitulé « Micropower energy harvesting », Solid-State Electronics 53 (2009) 684-693,
l'article de Yang et autres, intitulé « Design and vérification of a thermoelectric energy harvester with stacked polysilicon thermocouples by CMOS process", Sensors and actuators A157 (2010) 258-266,
l'article de Pin-Hsu Kao et autres, intitulé Fabrication and Characterization of CMOS-MEMS Thermoelectric Micro Generators, Sensors 2010, 10, 1315-1325,
l'article de Joao Paulo Carmo et autres, intitulé « A planar thermoelectric power generator for intégration in wearable microsystems », Sensors and Actuators A161 (2010), 199-204,
l'article de S.M. Yang et autres, intitulé « Development of a thermoelectric energy harvester with thermal isolation cavity by standard CMOS process", Sensors and Actuators A153 (2009), 244-250,
l'article de Ziyang Wang et autres, intitulé « Realization of a wearable miniaturized thermoelectric generator for human body applications », Sensors and Actuators A156 (2009), 95-102,
l'article de Hélène Lhermet et autres, intitulé « Efficient Power Management Circuit : From Thermal Energy Harvesting to Above-IC Microbattery Energy Storage », IEEE Journal of Solid-State Circuits, vol.43, n°1, Janvier 2008,
l'article de Till Huesgen et autres, intitulé « Design and fabrication of MEMS thermoelectric generators with high temperature efficiency", Sensors and Actuators A145-146 (2008), 423-429,
l'article de David Koester et autres, intitulé « Embedded thermoelectric coolers for semiconductor hot spot cooling », 2006 IEEE,
l'article de Hiromichi Ohta et autres, intitulé « Critical thickness for giant thermoelectric Seebeck coefficient of 2DEG confined in SrTiO3/SrTi0.8Nb0.2O3 superlattices", Thin Solid Films 516 (2008), 5916-5920.

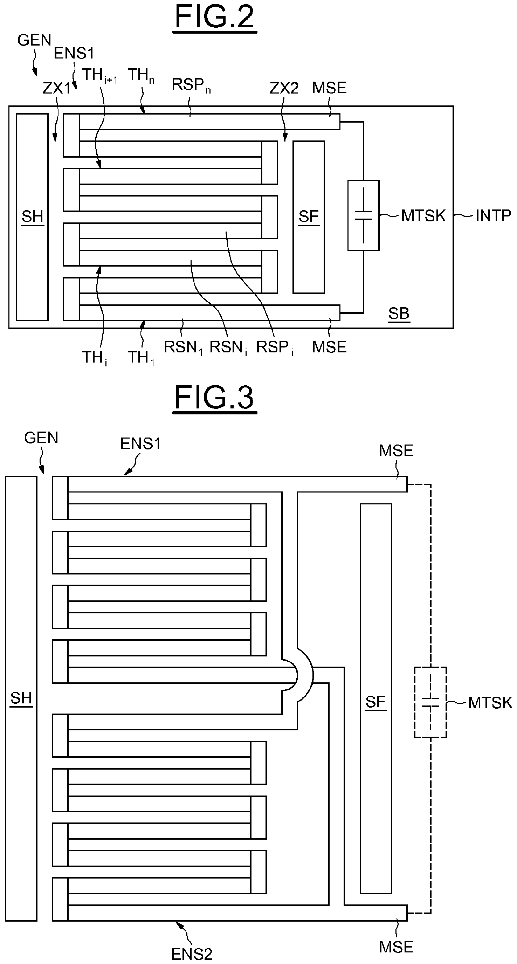

Cela étant il est particulièrement avantageux d'utiliser les générateurs GEN qui vont maintenant être décrits en référence aux figures 2 et suivantes, car ceux-ci sont compatibles avec des technologies de fabrication couramment utilisées en microélectronique, notamment celles utilisées pour la fabrication de mémoires non volatiles embarquées.

Sur la figure 2, le générateur comporte un ensemble de ENS1 de thermocouples THᵢ.

Chaque thermocouple THᵢ comporte ici une région semiconductrice en forme de barreau, de type de conductivité N, référencée RSNᵢ, et une région semiconductrice de type de conductivité P, référencée RSPᵢ également en forme de barreau.

Les deux régions semiconductrices du thermocouple THᵢ sont parallèles et reliées électriquement à une de leurs extrémités, et l'ensemble des thermocouples THᵢ sont reliés électriquement en série de façon à former une chaîne de barreaux parallèles ayant alternativement le type de conductivité N et le type de conductivité P.

Aux extrémités respectives et homologues des barreaux RSN₁ et RSPₙ appartenant respectivement au premier thermocouple TH₁ et au dernier thermocouple THₙ, sont connectés des moyens de sortie électriquement conducteurs MSE, par exemple des pistes métalliques ou un prolongement des barreaux correspondants.

La source chaude SH et la source froide SF sont respectivement disposées en regard des zones d'extrémité homologues ZX1 de toutes les régions semiconductrices parallèles des thermocouples et des zones d'extrémité homologues ZX2 de ces zones semiconductrices parallèles.

De par l'effet Seebeck, les couples PN soumis à la différence ou gradient de température vont générer un courant électrique qui va être délivré par les moyens de sortie MSE pour être par exemple stocké dans des moyens de stockage d'énergie électrique MSTK, comportant par exemple un condensateur connecté aux bornes des moyens MSE de façon à former un circuit électrique fermé.

En variante, les moyens MSE peuvent être reliés à une autre partie du circuit intégré de façon à former également un circuit fermé et pouvoir alimenter directement en énergie électrique cette autre partie du circuit intégré.

La puissance de sortie du générateur GEN dépend principalement du nombre de couples PN, de la surface du générateur, de la valeur du gradient de température, et de la nature des matériaux c'est-à-dire de leur coefficient Seebeck.

Les thermocouples de l'ensemble ENS1 sont thermiquement connectés en parallèle, c'est-à-dire qu'ils sont connectés de façon à être soumis tous ensemble au même gradient de température.

En variante, il est possible, comme illustré sur la figure 3, que le générateur comprenne au moins un autre ensemble de thermocouples, ici un deuxième ensemble de thermocouples ENS2, ayant une structure identique ou différente de celle du premier ensemble ENS1. Là encore, les thermocouples de l'autre ensemble ENS2 sont électriquement connectés en série et thermiquement connectés en parallèle.

Par ailleurs, les deux ensembles ENS1, ENS2 sont mutuellement électriquement connectés en parallèle, ils sont par ailleurs mutuellement également thermiquement connectés en parallèle, c'est-à-dire que, dans le cas présent, la source chaude SH et la source froide SF permettent d'appliquer à tous les thermocouples de tous les ensembles la différence de température créée par les sources chaude et froide SH et SF.

Ceci permet de fournir au niveau des moyens de sortie électriquement conducteurs MSE une plus grande puissance électrique.

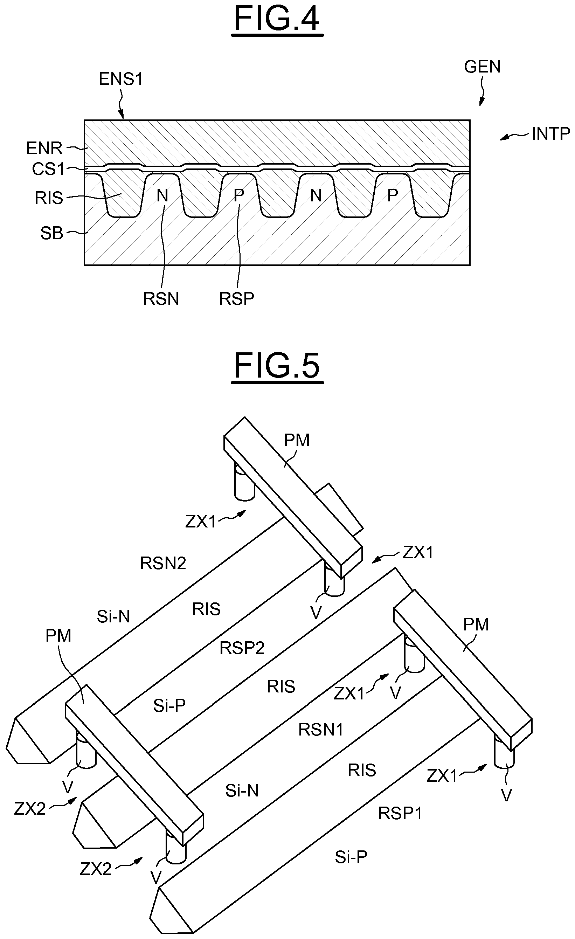

On va maintenant décrire en se référant aux figures 4 à 16, plusieurs exemples de structures de générateur GEN.

Sur la figure 4, le support du générateur GEN comprend une zone du substrat semiconducteur SB de l'interposeur INTP au sein de laquelle sont ménagées des régions isolantes parallèles RIS, par exemple des régions du type STI (Shallow Trench Isolation).

L'ensemble de thermocouples ENS1 est situé dans le substrat SB et comprend des régions semiconductrices parallèles RSN, RSP s'étendant dans le substrat, deux régions semiconductrices voisines RSN, RSP ayant respectivement l'un et l'autre des deux types de conductivité, en l'espèce le type de conductivité N et le type de conductivité P, et sont séparées par une région isolante RIS.

L'ensemble est recouvert par une couche isolante CS1, par exemple une couche de nitrure de silicium, elle-même recouverte d'un enrobage isolant, par exemple du dioxyde de silicium SiO₂.

La réalisation d'un tel générateur est parfaitement compatible avec le procédé de fabrication classique des mémoires embarquées, et ne nécessite aucune modification de procédé ni adjonction de niveau de masque.

L'enrobage isolant ENR est par exemple celui dans lequel sont réalisés les niveaux de métallisation de la partie d'interconnexion ITX.

A cet égard, et d'une façon générale, quelle que soit la structure de l'ensemble de thermocouple utilisée, le générateur comprend des moyens de connexion électriquement conducteurs assurant la liaison électrique entre les régions semiconductrices des thermocouples, ces moyens de connexion étant situés au dessus du substrat et reliant une zone d'extrémité d'une région semiconductrice ayant l'un des deux types de conductivité, par exemple le type de conductivité N, à une zone d'extrémité d'une région semiconductrice ayant l'autre type de conductivité, par exemple le type de conductivité P.

Par exemple, ces moyens de connexion sont enrobés dans le matériau isolant ENR et comprennent des pistes métalliques parallèles aux régions semiconductrices, et connectées auxdites zones d'extrémité par des liaisons électriques verticales, par exemple des contacts ou des vias.

Et, de façon à être parfaitement compatible avec des procédés de réalisation classiques de composants, par exemple des mémoires embarquées, les pistes métalliques des moyens de connexion sont situées sur au moins un des niveaux de métallisation de la partie d'interconnexion ITX.

Ceci est illustré plus particulièrement sur la figure 5, qui montre les moyens de connexion du générateur de la figure 4.

Ainsi, la zone d'extrémité ZX1 de la région semiconductrice RSN est électriquement connectée à la zone d'extrémité homologue ZX1 de la région RSP₁ par une piste métallique PM enjambant la région isolante RIS séparant ces deux régions RSN1 et RST1, cette piste métallique étant reliée aux zones d'extrémité ZX1 par des vias V.

De même, les zones d'extrémité ZX2 des régions RSN1 et RSP2 sont également connectées ensemble par une piste métallique PM enjambant la région RIS séparant ces deux régions RSN1 et RSP2. Cette piste métallique PM est connectée aux zones d'extrémité ZX2 par des vias V.

De même, les deux zones d'extrémité ZX1 des régions RSP2 et RSN2 sont connectées de la même façon par une piste métallique PM enjambant la région isolante RIS, cette piste métallique étant connectée aux zones ZX1 par l'intermédiaire de vias V.

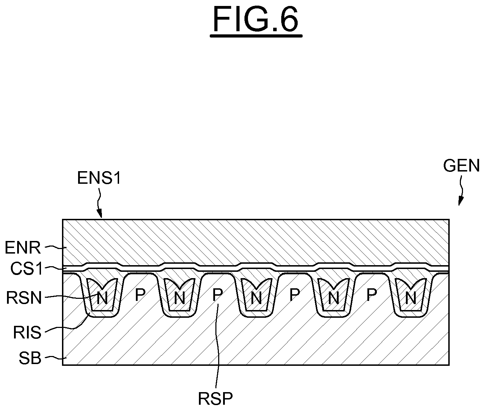

Le mode de réalisation de la figure 6 se distingue de celui de la figure 4 et de la figure 5 en ce sens que l'ensemble ENS1 de thermocouples comprend d'une part, des premières régions semiconductrices parallèles RSP s'étendant toutes dans le substrat SB et ayant toutes l'un des deux types de conductivité, en l'espèce le type de conductivité P. Deux premières régions semiconductrices voisines RSP sont séparées par une région isolante RIS.

L'ensemble de thermocouples comprend d'autre part des deuxièmes régions semiconductrices parallèles RSN s'étendant toutes respectivement au sein des régions isolantes RIS et ayant toutes l'autre type de conductivité, en l'espèce le type de conductivité N.

Il convient de noter ici que ce mode de réalisation présente l'avantage d'offrir un générateur ayant, pour le même encombrement surfacique que celui de la figure 4, un plus grand nombre de couples PN, ce qui permet d'augmenter la puissance électrique délivrée.

Par rapport à un procédé classique de fabrication du type mémoire embarquée, le procédé de fabrication du générateur est légèrement modifié. Plus précisément, après formation des tranchées dans le silicium, et formation sur les parois des tranchées d'une couche d'oxyde tapissant ces dernières, le polysilicium est déposé, dopé in situ, puis le silicium débordant des tranchées est ensuite gravé de façon classique, par exemple par une gravure sèche.

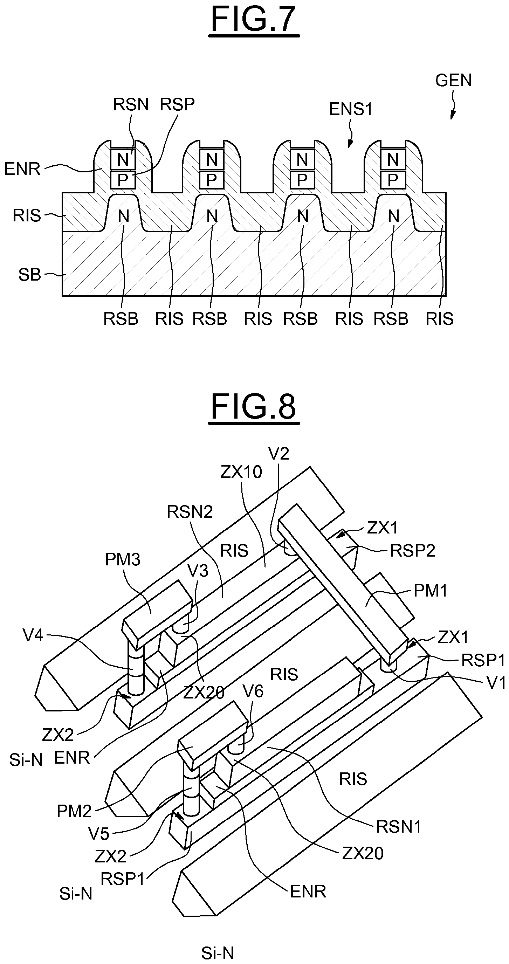

Dans le mode de réalisation des figures 7 et 8, la zone de substrat sur laquelle est formé le générateur GEN comporte, entre les régions isolantes parallèles RIS, des régions de substrat RSB ayant toutes le même type de conductivité, à savoir ici par exemple le type de conductivité N.

Et, l'ensemble ENS1 de thermocouples comprend ici au dessus de chaque région de substrat RSB, au moins une paire de régions semiconductrices RSP, RSN, enrobées dans un matériau isolant ENR et ayant respectivement les deux types de conductivité.

Plus précisément, dans cet exemple, les régions semiconductrices inférieures RSP des paires ont le type de conductivité P et sont surmontées par les régions RSN qui ont le type de conductivité N.

L'enrobage isolant comporte, de façon classique, du nitrure de silicium et du dioxyde de silicium et correspond à l'enrobage classique des mémoires non volatiles à double grilles (dont une est flottante). A cet égard, le procédé de réalisation du thermocouple du générateur GEN de la figure 7 est analogue au procédé de fabrication d'un plan-mémoire à grilles flottantes.

Là encore, comme illustré sur la figure 8, des pistes métalliques et des vias permettent de relier électriquement en série les thermocouples. Plus précisément, une première zone d'extrémité ZX1 d'une première région semiconductrice RSP1 est reliée à la première zone d'extrémité homologue ZX10 de la région semiconductrice RSN2 de la paire voisine par des vias V1 et V2 et une portion de piste métallique PM1.

Par ailleurs, les deuxièmes zones d'extrémité ZX20 des régions RSN1 et RSN2 sont reliées aux deuxièmes zones d'extrémité homologues ZX2 des régions RSP1 et RSP2 par des vias V3, V4, V5, V6 et des portions de pistes métalliques PM2, PM3.

Il convient de noter ici que tout comme dans le mode de réalisation de la figure 4, la portion PM1 enjambe la région isolante RIS séparant les deux paires de régions semiconductrices RSP1, RSN1 et RSP2, RSN2.

Il serait également possible, en variante, que les paires de régions semiconductrices soient situées non pas au dessus des régions de substrat mais au dessus des régions isolantes RIS.

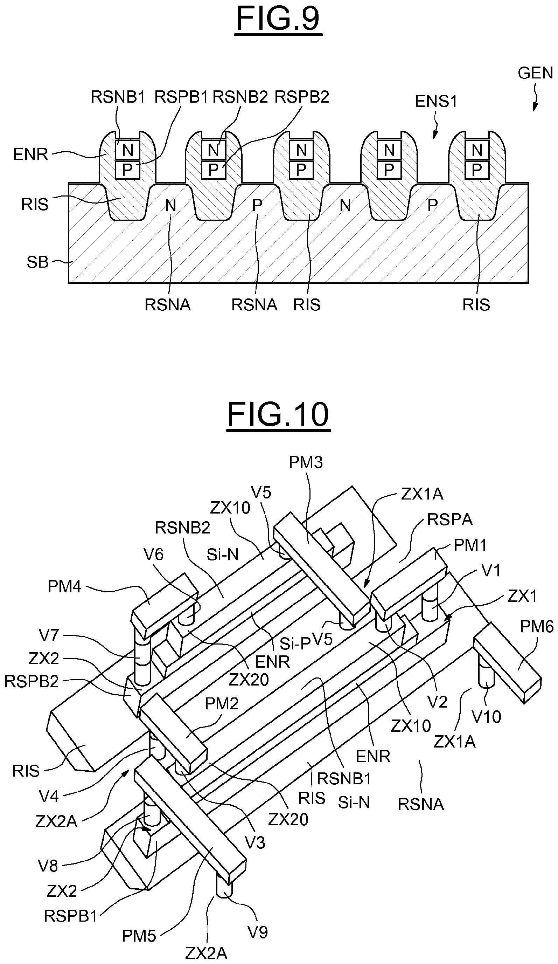

C'est le cas notamment dans le mode de réalisation de la figure 9, dans lequel l'ensemble ENS1 de thermocouples du générateur GEN comprend en outre des régions semiconductrices parallèles RSNA, RSPA s'étendant dans le substrat, et ayant respectivement et alternativement l'un et l'autre des deux types de conductivité (N et P) en étant séparés par des régions isolantes parallèles RIS.

Et, comme indiqué ci-avant, outre ces régions de substrat RSNA, RSPA, l'ensemble ENS1 comporte, au dessus de chaque région isolante, une paire de régions semiconductrices RSPBi et RSNBi enrobées dans un matériau isolant ENR et ayant respectivement les deux types de conductivité N et P.

Ainsi, par rapport au mode de réalisation de la figure 7, et pour un même encombrement surfacique, le générateur GEN de la figure 9 présente un nombre de couples PN augmenté par rapport au nombre de couples PN du générateur de la figure 7.

Là encore, le générateur de la figure 9 est parfaitement compatible avec des procédés de fabrication de mémoire non-volatile embarquée.

Les moyens de liaison électrique entre les différents éléments des différents thermocouples sont illustrés schématiquement sur la figure 10.

Plus précisément, une première zone d'extrémité ZX1 de la région semiconductrice RSPB1 située au dessus de la région isolante RIS est reliée à la première zone d'extrémité homologue ZX10 de la région RSNB1 par des vias V1 et V2 et une portion de lignes métalliques PM1.

La deuxième zone d'extrémité ZX20 de la région RNSB1 est reliée à la deuxième zone d'extrémité ZX2A de la région de substrat RSPA par des vias V3 et V4 et une portion de piste métallique PM2.

La continuité électrique entre la région RSPA et la région RSNB2 est assurée par des vias V5 et une portion de pistes métallique PM3, connectant les deux premières zones d'extrémité homologues ZX1A et ZX10 de la région RSPA et de la région RSNB2.

La continuité électrique entre les régions RSNB2 et RSPB2 est assurée par des vias V6 et V7 et une portion de piste métallique PM4 reliant les deux extrémités homologues ZX20 et ZX2 de ces deux régions.

La continuité électrique entre la région RSPB1 et la région de substrat RSNA voisine est assurée, au niveau de leurs deuxièmes zones d'extrémité respectives ZX2 et ZX2A par des vias V8 et V9 et une portion de piste métallique PM5.

De même, la continuité électrique entre cette région RSNA et la région semiconductrice RSPB de la paire voisine est assurée par un via V10 et une portion de piste métallique PM6 au niveau de la zone d'extrémité ZX1A de la région RSNA.

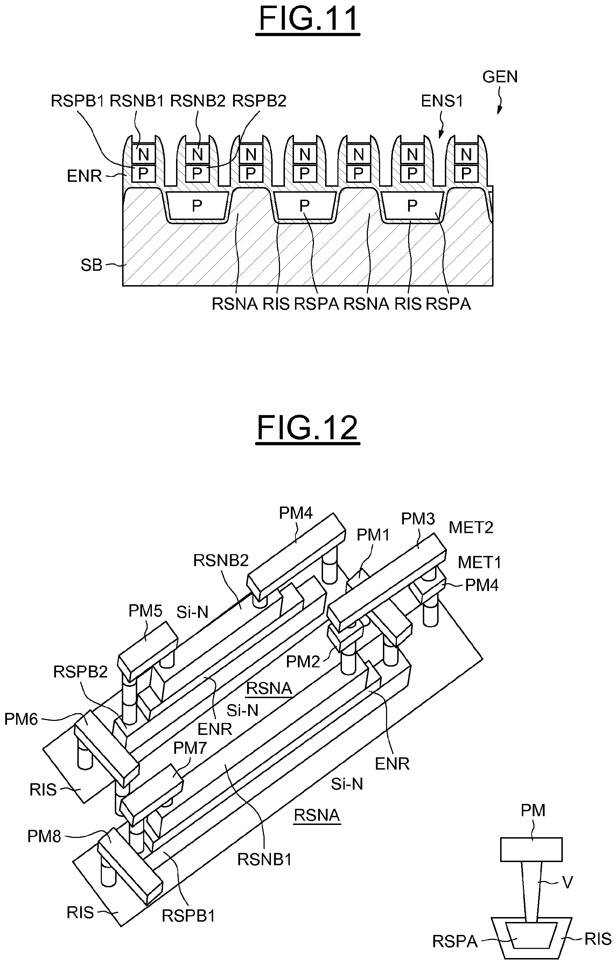

Le mode de réalisation du générateur GEN de la figure 11 diffère ce celui de la figure 9 par le fait que l'ensemble ENS1 de thermocouples comprend en outre des régions semiconductrices parallèles s'étendant au sein des régions isolantes RIS.

Plus précisément, l'ensemble ENS1 de thermocouples comprend, des régions de substrat parallèles RSNA ayant toutes le même type de conductivité, en l'espèce le type de conductivité N, des régions semiconductrices RSPA s'étendant au sein des régions isolantes RIS séparant ces régions de substrat RSNA, et ayant toutes l'autre type de conductivité, à savoir le type de conductivité P, et, au dessus de chaque région de substrat RSNA, des paires de régions semiconductrices parallèles RSPBi et RSNBi enrobées dans un matériau isolant ENR.

Ainsi, un tel mode de réalisation, parfaitement compatible avec la technologie des mémoires non-volatiles embarquées, comporte, par rapport au mode de réalisation de la figure 4, un nombre beaucoup plus important de couples PN pour une même empreinte surfacique, ce qui le rend beaucoup plus efficace en termes d'énergie électrique produite.

Les moyens de connexion électrique entre les différentes parties des différents thermocouples du générateur de la figure 11 sont illustrés schématiquement sur la figure 12. Cette fois-ci, certains de ces moyens s'étendent à la fois sur deux niveaux de métallisation du circuit intégré, à savoir le niveau de métal 1 MET1 et le niveau de métal 2 MET2.

Tout comme dans les modes de réalisation précédents, la continuité électrique entre les différents éléments des différents thermocouples connectés en série s'effectue par des vias et des portions de piste métallique connectant deux zones d'extrémité de deux régions semiconductrices ayant les deux types de conductivité opposés N et P.

Et, alors que la connexion électrique entre la région RSPB1 et la région RSNA s'effectue par une portion de piste métallique PM1 située au niveau de métal MET1, la connexion électrique entre la région RSNB1 et la région RSPA encapsulée dans la région isolante RIS s'effectue notamment par trois portions de pistes métalliques PM2, PM3, PM4 situées aux niveaux de métallisation MET1 et MET2.

La partie inférieure droite de la figure 12 montre la connexion entre une portion de piste métallique PM et une région semiconductrice RSPA encapsulée dans une région RIS par l'intermédiaire d'un via V traversant la région RIS pour venir contacter la région RSPA.

Les autres continuités électriques des régions illustrées sur la figure 12 comportent notamment des portions de piste métallique PM4, PM5, PM6, PM7, PM8.

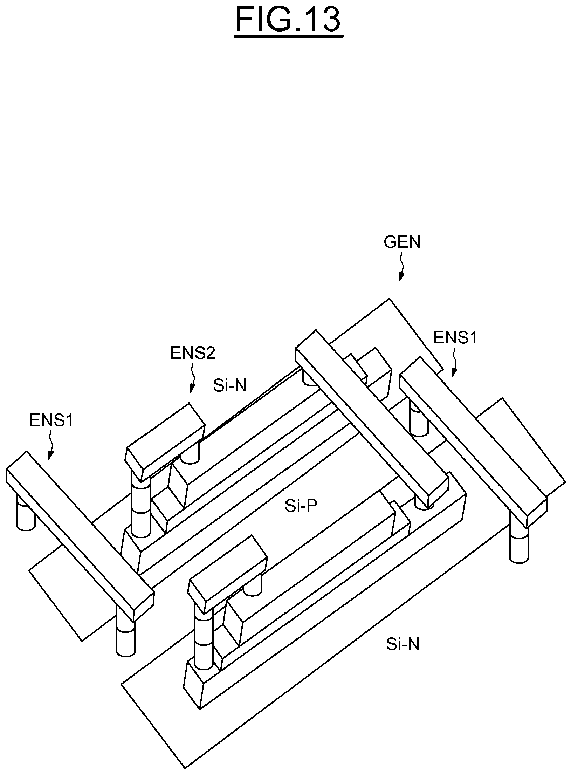

Comme il a été indiqué ci avant en référence à la figure 3, il est possible de connecter électriquement en parallèle deux ensembles de thermocouples. Un exemple d'une telle réalisation est illustré sur la figure 13.

Sur cette figure, le générateur GEN comprend par exemple l'ensemble de thermocouples ENS1 illustré sur les figures 4 et 5, et l'ensemble de thermocouples ENS2 illustré sur les figures 7 et 8.

Le silicium est un très bon conducteur thermique, de telle sorte que les deux niveaux de température présents respectivement aux deux extrémités des thermocouples et initialement différents peuvent rapidement s'égaliser, ce qui stoppe alors la génération de puissance électrique.

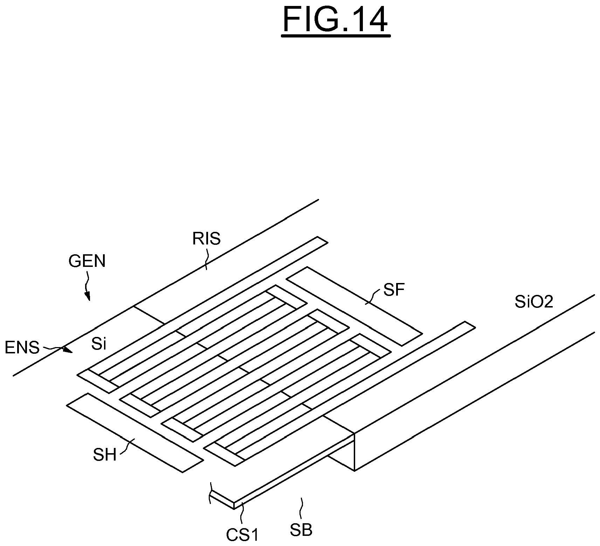

Le mode de réalisation de la figure 14 permet, d'une façon générale, notamment par l'utilisation de polysilicium, de retarder l'équilibre des températures tout en restant compatible avec des technologies de fabrication CMOS classiques.

Plus précisément, comme illustré très schématiquement sur la figure 14, une partie de l'ensemble de thermocouples ENS du générateur GEN s'étend sur une partie du substrat SB recouverte d'une couche isolante CS1, par exemple une fine couche de dioxyde de silicium, tandis que l'autre partie de l'ensemble de thermocouples s'étend sur une région isolante RIS, plus épaisse que la couche isolante recouvrant le substrat de silicium, cette couche RIS pouvant être une tranchée isolante peu profonde du type STI.

De ce fait, compte tenu que le matériau isolant, généralement du dioxyde de silicium, est un très mauvais conducteur thermique, l'équilibre des températures entre les deux extrémités des thermocouples est retardé, ce qui améliore l'efficacité du générateur.

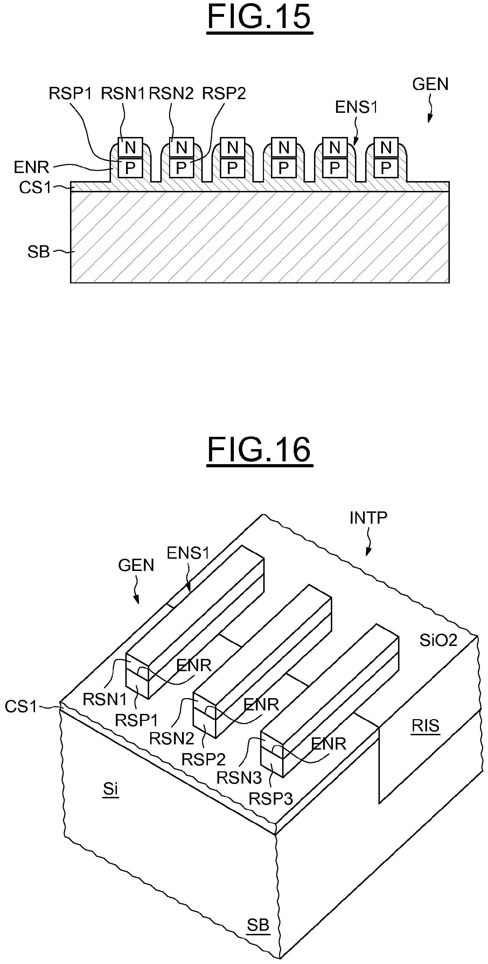

Un exemple plus précis de réalisation est illustré sur les figures 15 et 16.

Sur ces figures, la zone correspondante de substrat SB est recouverte d'une couche isolante fine CS1 de dioxyde de silicium.

L'ensemble ENS1 de thermocouples comporte plusieurs paires parallèles de régions semiconductrices parallèles RSNi, RSPi ayant respectivement les deux types de conductivité N et P, ces paires s'étendant à cheval sur la couche isolante CS1 et sur la région isolante RIS plus, épaisse que la couche isolante CS1.

## Revendications

1. Interposeur pour l'interconnexion de plusieurs éléments d'une structure intégrée tridimensionnelle, **caractérisé en ce qu'**il comprend un substrat semiconducteur (SB) et, au dessus du substrat, une partie d'interconnexion électriquement conductrice (ITX) noyée dans un enrobage isolant, et au moins un générateur thermoélectrique (GEN) comportant au moins un ensemble (ENS1) de thermocouples électriquement connectés en série et thermiquement connectés en parallèle, une partie au moins des thermocouples étant noyée au sein de l'enrobage isolant (ENR) entre ladite partie d'interconnexion et le substrat semiconducteur.

2. Interposeur selon la revendication 1, comprenant des régions isolantes (RIS), et ledit au moins un ensemble de thermocouples (ENS1) comprend des régions semiconductrices parallèles ayant chacune un type de conductivité pris parmi deux types de conductivité opposés, dont certaines au moins d'entre elles s'étendent dans le substrat (SB) entre des régions isolantes parallèles (RIS) ou dont certaines au moins d'entre elles s'étendent à cheval au dessus d'une partie du substrat (SB) en étant électriquement isolées de ladite partie de substrat et au dessus d'au moins une partie des régions isolantes (RIS), ou dont certaines au moins d'entre elles sont enrobées d'un matériau isolant (ENR) et s'étendent intégralement au dessus de régions isolantes parallèles ou intégralement au dessus des régions de substrat situées entre lesdites régions isolantes parallèles, lesdites régions semiconductrices étant électriquement reliées en série de façon à former une chaîne de régions ayant alternativement l'un et l'autre des deux types de conductivité.

3. Interposeur selon la revendication 2, dans lequel les régions semiconductrices sont des régions de polysilicium dopées N ou P.

4. Interposeur selon la revendication 2 ou 3, comprenant des moyens de connexion électriquement conducteurs (PM, V) assurant la liaison électrique entre les régions semiconductrices, ces moyens de connexion étant situés au dessus du substrat et reliant une zone d'extrémité d'une région semiconductrice ayant l'un des deux types de conductivité à une zone d'extrémité d'une région semiconductrice ayant l'autre type de conductivités.

5. Interposeur selon la revendication 4, dans lequel les moyens de connexion sont enrobés dans un matériau isolant et comprennent des pistes métalliques (PM) parallèles aux régions semiconductices connectées auxdites zones d'extrémité par des liaisons électriques verticales (V).

6. Interposeur selon l'une des revendications 2 à 5, dans lequel le substrat comporte des régions isolantes parallèles (RIS), ledit au moins un ensemble de thermocouples (ENS1) est situé dans le substrat (SB) et comprend des régions semiconductrices parallèles (RSN, RSP) s'étendant dans le substrat, deux régions semiconductrices voisines ayant respectivement l'un et l'autre des deux types de conductivité et étant séparées par une région isolante.

7. Interposeur selon l'une des revendications 2 à 5, dans lequel le substrat comporte des régions isolantes parallèles (RIS), ledit au moins un ensemble de thermocouples comprend des premières régions semiconductrices parallèles (RSP) s'étendant toutes dans le substrat et ayant toutes l'un des deux types de conductivité, deux premières régions semiconductrices voisines étant séparées par une région isolante, et des deuxièmes régions semiconductrices parallèles (RSN) s'étendant toutes respectivement au sein des régions isolantes et ayant toutes l'autre type de conductivité.

8. Interposeur selon l'une des revendications 2 à 5, dans lequel le substrat comporte des régions isolantes parallèles (RIS) et les régions de substrat situées entre les régions isolantes ont toutes le même type de conductivité, et ledit au moins un ensemble de thermocouples comprend au dessus de chaque région de substrat au moins une paire de régions semiconductrices (RSN, RSP) enrobées dans un matériau isolant (ENR) et ayant respectivement les deux types de conductivité.

9. Interposeur selon l'une des revendications 2 à 5, dans lequel le substrat comporte une partie recouverte d'une couche isolante (CS1) et ledit au moins un ensemble de thermocouples comportent plusieurs paires parallèles de régions semiconductrices parallèles enrobées dans un matériau isolant ayant respectivement les deux types de conductivité, lesdites paires s'étendant à cheval sur ladite couche isolante (CIS) et une région isolante (RIS) plus épaisse que ladite couche isolante.

10. Interposeur selon l'une des revendications 2 à 5 dans lequel le substrat comporte des régions isolantes parallèles et ledit au moins un ensemble de thermocouples (ENS1) comprend au dessus de chaque région isolante au moins une paire de régions semiconductrices enrobées dans un matériau isolant ayant respectivement les deux types de conductivité.

11. Interposeur selon l'une des revendications 2 à 5, dans lequel le substrat comporte des régions isolantes parallèles, et ledit au moins un ensemble de thermocouples comprend des régions semiconductrices parallèles s'étendant dans le substrat, deux régions semiconductrices voisines ayant respectivement l'un et l'autre des deux types de conductivité et étant séparées par une région isolante, et au dessus de chaque région isolante (RIS), au moins une paire de régions semiconductrices (RSNBi, RSPBi) enrobées dans un matériau isolant ayant respectivement les deux types de conductivité.

12. Interposeur selon l'une des revendications 2 à 5, dans lequel le substrat comporte des régions isolantes parallèles et ledit au moins un ensemble de thermocouples comprend des premières régions semiconductrices parallèles (RSNA) s'étendant respectivement entre les régions isolantes et ayant toutes l'un des deux types de conductivité, des deuxièmes régions semiconductrices parallèles (RSPA) s'étendant respectivement au sein des régions isolantes (RIS) et ayant toutes l'autre type de conductivité, et au dessus de chaque première région, au moins une paire de régions semiconductrices (RSNBi, RSPBi) enrobées dans un matériau isolant ayant respectivement les deux types de conductivité.

13. Interposeur selon l'une des revendications 1 à 12, comprenant au moins un autre ensemble de thermocouples (ENS2) électriquement connectés en série et thermiquement connectés en parallèle, tous les ensembles (ENS1, ENS2) étant mutuellement électriquement et thermiquement connectés en parallèle.

14. Interposeur selon la revendication 13, dans lequel l'un des ensembles de thermocouples est un ensemble selon la revendication 6 et l'autre ensemble de thermocouples est un ensemble selon la revendication 10.

15. Structure intégrée tridimensionnelle, comprenant au moins deux éléments électriquement interconnectés par un interposeur, **caractérisée en ce que** l'interposeur est un interposeur selon l'une des revendications 1 à 14 dont le générateur thermoélectrique (GEN) est en couplage thermique avec l'un au moins desdits éléments de façon à ce que ledit un au moins desdits éléments soit apte en fonctionnement à générer un gradient de température entre les premières zones d'extrémités homologues et les deuxièmes zones d'extrémités homologues de tous les thermocouples, l'interposeur comprenant en outre des moyens de sortie (MSE) électriquement conducteurs couplés audit générateur pour délivrer l'énergie électrique produite par ledit générateur.

16. Structure selon la revendication 15, comprenant en outre un module de gestion d'énergie (PWM) connecté aux moyens de sortie (MSE), situé sur l'interposeur, et configuré pour gérer l'énergie électrique produite par le générateur.

17. Structure intégrée selon la revendication 16, comprenant en outre des moyens de stockage d'énergie électrique (MSTK), électriquement couplés auxdits moyens de sortie électriquement conducteurs.

18. Structure intégrée selon la revendication 15, 16 ou 17, dans laquelle l'interposeur comprend au moins un niveau de métallisation au dessus d'un substrat semiconducteur et au moins une partie des liaisons électriques entre les thermocouples comporte des pistes métalliques s'étendant sur au moins un niveau de métallisation.

## Patentansprüche

1. Interposer für das Zusammenschalten mehrerer Elemente einer integrierten dreidimensionalen Struktur, **dadurch gekennzeichnet, dass** er ein Halbleitersubstrat (SB) umfasst und, über dem Substrat, einen elektrisch leitenden Zusammenschaltungsteil (ITX), der in einer isolierenden Beschichtung eingelassen ist, und mindestens einen thermoelektrischen Generator (GEN), der mindestens eine Einheit (ENS1) von Thermoelementen umfasst, die elektrisch in Reihe geschaltet sind und thermisch parallel geschaltet sind, wobei mindestens ein Teil der Thermoelemente innerhalb der isolierenden Beschichtung (ENR) zwischen dem Zusammenschaltungsteil und dem Halbleitersubstrat eingelassen ist.

2. Interposer nach Anspruch 1, der isolierende Bereiche (RIS) umfasst und wobei die mindestens eine Einheit von Thermoelementen (ENS1) parallele Halbleiterbereiche umfasst, die jeweils einen Leitfähigkeitstyp haben, der aus zwei entgegengesetzten Leitfähigkeitstypen ausgewählt ist, von welchen sich mindestens bestimmte in dem Substrat (SB) zwischen parallelen isolierenden Bereichen (RIS) erstrecken, oder von welchen sich mindestens bestimmte über einem Teil des Substrats (SB) überlagert erstrecken, indem sie elektrisch von dem Substratteil getrennt sind, und über mindestens einem Teil der isolierenden Bereiche (RIS), oder von welchen mindestens bestimmte mit einem isolierenden Material (ENR) überzogen sind und sich integral über parallelen isolierenden Bereichen erstrecken oder integral über Substratbereichen, die zwischen parallelen isolierenden Bereichen liegen, wobei die Halbleiterbereiche elektrisch in Reihe derart geschaltet sind, dass sie eine Kette von Bereichen bilden, die abwechselnd den einen und den anderen der zwei Leitfähigkeitstypen haben.

3. Interposer nach Anspruch 2, wobei die Halbleiterbereiche N- oder P-dotierte Polysiliziumbereiche sind.

4. Interposer nach Anspruch 2 oder 3, der Mittel zum elektrischen Verbinden von Leitern (PM, V) umfasst, die die elektrische Verbindung zwischen den Halbleiterbereichen sicherstellen, wobei diese Verbindungsmittel über dem Substrat liegen und eine Endzone eines Halbleiterbereichs, der einen der zwei Leitfähigkeitstypen hat, mit einer Endzone eines Halbleiterbereichs, die den anderen Leitfähigkeitstyp hat, verbinden.

5. Interposer nach Anspruch 4, wobei die Verbindungsmittel mit einem isolierenden Material überzogen sind und metallische Bahnen (PM) parallel zu den Halbleiterbereichen umfassen, die mit den Endzonen durch vertikale elektrische Verbindungen (V) verbunden sind.

6. Interposer nach einem der Ansprüche 2 bis 5, wobei das Substrat parallele isolierende Bereiche (RIS) umfasst, wobei die mindestens eine Einheit von Thermoelementen (ENS1) in dem Substrat (SB) liegt und parallele Halbleiterbereiche (RSN, RSP) umfasst, die sich in dem Substrat erstrecken, wobei zwei benachbarte Halbleiterbereiche jeweils den einen und den anderen der zwei Leitfähigkeitstypen haben und durch einen isolierenden Bereich getrennt sind.

7. Interposer nach einem der Ansprüche 2 bis 5, wobei das Substrat parallele isolierende Bereiche (RIS) umfasst, wobei die mindestens eine Einheit von Thermoelementen erste parallele Halbleiterbereiche (RSP) umfasst, die sich alle in dem Substrat erstrecken und alle einen der zwei Leitfähigkeitstypen haben, wobei zwei erste benachbarte Halbleiterbereiche durch einen isolierenden Bereich getrennt sind, und sich zweite parallele Halbleiterbereiche (RSN) alle jeweils innerhalb der isolierenden Bereiche erstrecken und alle den anderen Leitfähigkeitstyp haben.

8. Interposer nach einem der Ansprüche 2 bis 5, wobei das Substrat parallele isolierende Bereiche (RIS) umfasst und die Substratbereiche, die zwischen den isolierenden Bereichen liegen, alle denselben Leitfähigkeitstyp haben, und wobei mindestens eine Einheit von Thermoelementen über jedem Substratbereich mindestens ein Paar von Halbleiterbereichen (RSN, RSP) umfasst, das mit einem isolierenden Material (ENR) überzogen ist und jeweils die zwei Leitfähigkeitstypen hat.

9. Interposer nach einem der Ansprüche 2 bis 5, wobei das Substrat einen Teil umfasst, der mit einer Isolierschicht (CS1) bedeckt ist und wobei die mindestens eine Einheit von Thermoelementen mehrere parallele Paare paralleler Halbleiterbereiche umfasst, die mit einem isolierenden Material überzogen sind, das jeweils die zwei Leitfähigkeitstypen hat, wobei sich die Paare überlagert auf der isolierenden Schicht (CIS) und einem isolierenden Bereich (RIS), der dicker ist als die isolierende Schicht, erstrecken.

10. Interposer nach einem der Ansprüche 2 bis 5, wobei das Substrat parallele isolierende Bereiche umfasst und die mindestens eine Einheit von Thermoelementen (ENS1) über jedem isolierenden Bereich mindestens ein Paar Halbleiterbereiche, die mit einem isolierenden Material überzogen sind, das jeweils die zwei Leitfähigkeitstypen hat, umfasst.

11. Interposer nach einem der Ansprüche 2 bis 5, wobei das Substrat parallele isolierende Bereiche umfasst und die mindestens eine Einheit von Thermoelementen parallele Halbleiterbereiche umfasst, die sich in dem Substrat erstrecken, wobei zwei benachbarte Halbleiterbereiche jeweils den einen und den anderen der zwei Leitfähigkeitstypen haben und durch einen isolierenden Bereich getrennt sind, und über jedem isolierenden Bereich (RIS) mindestens ein Paar von Halbleiterbereichen (RSNBi, RSPBi), die mit einem isolierenden Material, das jeweils die zwei Leitfähigkeitstypen hat, überzogen sind.

12. Interposer nach einem der Ansprüche 2 bis 5, wobei das Substrat parallele isolierende Bereiche umfasst und die mindestens eine Einheit von Thermoelementen erste parallele Halbleiterbereiche (RSNA) umfasst, die sich jeweils zwischen den isolierenden Bereichen erstrecken und alle einen der zwei Leitfähigkeitstypen haben, zweite parallele Halbleiterbereiche (RSPA), die sich jeweils innerhalb der isolierenden Bereiche (RIS) erstrecken und alle den anderen Leitfähigkeitstyp haben, und über jedem ersten Bereich mindestens ein Paar von Halbleiterbereichen (RSNBi, RSPBi), die mit einem isolierenden Material beschichtet sind, das jeweils die zwei Leitfähigkeitstypen hat.

13. Interposer nach einem der Ansprüche 1 bis 12, der mindestens eine andere Einheit von Thermoelementen (ENS2) umfasst, die elektrisch in Reihe geschaltet und thermisch parallel geschaltet sind, wobei alle Einheiten (ENS1, ENS2) gegenseitig elektrisch und thermisch parallel geschaltet sind.

14. Interposer nach Anspruch 13, wobei eine der Einheiten von Thermoelementen eine Einheit nach Anspruch 6 ist und die andere Einheit von Thermoelementen eine Einheit nach Anspruch 10 ist.

15. Integrierte dreidimensionale Struktur, die mindestens zwei elektrisch durch einen Interposer zusammengeschaltete Elemente umfasst, **dadurch gekennzeichnet, dass** der Interposer ein Interposer nach einem der Ansprüche 1 bis 14 ist, dessen thermoelektrischer Generator (GEN) in thermischer Kopplung mit mindestens einem der Elemente derart ist, dass das mindestens eine der Elemente geeignet ist, beim Betrieb einen Temperaturgradienten zwischen den ersten homologen Endzonen und den zweiten homologen Endzonen aller Thermoelemente zu erzeugen, wobei der Interposer außerdem elektrisch leitende Ausgangsmittel (MSE) umfasst, die mit dem Generator gekoppelt sind, um die elektrische Energie, die von dem Generator erzeugt wird, zu liefern.

16. Struktur nach Anspruch 15, die außerdem ein Energieverwaltungsmodul (PWM) umfasst, das mit den Ausgangsmitteln (MSE) verbunden ist, das auf dem Interposer liegt und konfiguriert ist, um die elektrische Energie, die von dem Generator erzeugt wird, zu verwalten.

17. Integrierte Struktur nach Anspruch 16, die außerdem Mittel zum Speichern elektrischer Energie (MSTK) umfasst, die elektrisch mit den elektrisch leitenden Ausgangsmitteln gekoppelt sind.

18. Integrierte Struktur nach Anspruch 15, 16 oder 17, wobei der Interposer mindestens ein Metallisierungsniveau über einem Halbleitersubstrat umfasst, und mindestens ein Teil der elektrischen Verbindungen zwischen den Thermoelementen metallische Bahnen umfasst, die sich auf mindestens einem Metallisierungsniveau erstrecken.

## Claims

1. Interposer for the interconnection of several elements of a three-dimensional integrated structure, **characterized in that** it comprises a semiconductor substrate (SB) and, on top of the substrate, an electrically conducting interconnection part (ITX) buried in an insulating coating, and at least one thermo-electric generator (GEN) comprising at least one assembly (ENS1) of thermocouples electrically connected in series and thermally connected in parallel,
at least a part of the thermocouples being buried within the insulating coating (ENR) between the said interconnection part and the semiconductor substrate.

2. Interposer according to Claim 1, comprising insulating regions (RIS), and the said at least one assembly of thermocouples (ENS1) comprises parallel semiconductor regions each having one type of conductivity taken from between two types of opposing conductivity, at least some of which run within the substrate (SB) between parallel insulating regions (RIS) or at least some of which run over and above a part of the substrate (SB) while being electrically isolated from the said part of the substrate and above at least one part of the insulating regions (RIS), or at least some of which are coated with an insulating material (ENR) and run in their entirety above parallel insulating regions or in their entirety above regions of the substrate situated between the said parallel insulating regions, the said semiconductor regions being electrically connected in series so as to form a chain of regions having alternately one and the other of the two types of conductivity.

3. Interposer according to Claim 2, in which the semiconductor regions are regions of N or P doped polysilicon.

4. Interposer according to Claim 2 or 3, comprising electrically conducting connection means (PM, V) providing the electrical link between the semiconductor regions, these connection means being situated on top of the substrate and connecting one end area of a semiconductor region having one of the two types of conductivity to an end area of a semiconductor region having the other type of conductivity.

5. Interposer according to Claim 4, in which the connection means are coated with an insulating material and comprise metal tracks (PM) parallel to the semiconductor regions connected to the said end areas via vertical electrical links (V).

6. Interposer according to one of Claims 2 to 5, in which the substrate comprises parallel insulating regions (RIS), and the said at least one assembly of thermocouples (ENS1) is situated in the substrate (SB) and comprises parallel semiconductor regions (RSN, RSP) running in the substrate, two neighbouring semiconductor regions each one respectively having one and the other of the two types of conductivity and being separated by an insulating region.

7. Interposer according to one of Claims 2 to 5, in which the substrate comprises parallel insulating regions (RIS), and the said at least one assembly of thermocouples comprises first parallel semiconductor regions (RSP) all running in the substrate and all having one of the two types of conductivity, two first neighbouring semiconductor regions being separated by an insulating region, and second parallel semiconductor regions (RSN) all running respectively within insulating regions and all having the other type of conductivity.

8. Interposer according to one of Claims 2 to 5, in which the substrate comprises parallel insulating regions (RIS) and the substrate regions situated between the insulating regions all have the same type of conductivity, and the said at least one assembly of thermocouples comprises, on top of each substrate region, at least one pair of semiconductor regions (RSN, RSP) coated with an insulating material (ENR) and respectively having the two types of conductivity.

9. Interposer according to one of Claims 2 to 5, in which the substrate comprises a part covered by an insulating layer (CS1) and the said at least one assembly of thermocouples comprises several parallel pairs of parallel semiconductor regions coated with an insulating material respectively having the two types of conductivity, the said pairs running along the top of the said insulating layer (CS1) and an insulating region (RIS) thicker than the said insulating layer.

10. Interposer according to one of Claims 2 to 5 in which the substrate comprises parallel insulating regions and the said at least one assembly of thermocouples (ENS1) comprises, on top of each insulating region, at least one pair of semiconductor regions coated with an insulating material respectively having the two types of conductivity.

11. Interposer according to one of Claims 2 to 5, in which the substrate comprises parallel insulating regions, and the said at least one assembly of thermocouples comprises parallel semiconductor regions running in the substrate, two neighbouring semiconductor regions respectively having one and the other of the two types of conductivity and being separated by an insulating region and, on top of each insulating region (RIS), at least one pair of semiconductor regions (RSNBi, RSPBi) coated with an insulating material respectively having the two types of conductivity.

12. Interposer according to one of Claims 2 to 5, in which the substrate comprises parallel insulating regions and the said at least one assembly of thermocouples comprises first parallel semiconductor regions (RSNA) respectively running between the insulating regions and all having one of the two types of conductivity, second parallel semiconductor regions (RSPA) respectively running within the insulating regions (RIS) and all having the other type of conductivity and, on top of each first region, at least one pair of semiconductor regions (RSNBi, RSPBi) coated with an insulating material respectively having the two types of conductivity.

13. Interposer according to one of Claims 1 to 12, comprising at least one other assembly of thermocouples (ENS2) electrically connected in series and thermally connected in parallel, all the assemblies (ENS1, ENS2) being mutually electrically and thermally connected in parallel.

14. Interposer according to Claim 13, in which one of the assemblies of thermocouples is an assembly according to Claim 6 and the other assembly of thermocouples is an assembly according to Claim 10.

15. Three-dimensional integrated structure, comprising at least two elements electrically interconnected by an interposer, **characterized in that** the interposer is an interposer according to one of Claims 1 to 14 whose thermo-electric generator (GEN) is thermally coupled with at least one of the said elements in such a manner that the said at least one of the said elements is capable, in operation, of generating a temperature gradient between the corresponding first end areas and the corresponding second end areas of all the thermocouples, the interposer furthermore comprising electrically conducting output means (MSE) coupled to the said generator in order to deliver the electrical power produced by the said generator.

16. Structure according to Claim 15, furthermore comprising a power management module (PWM) connected to the output means (MSE), situated on the interposer, and configured for managing the electrical power produced by the generator.

17. Integrated structure according to Claim 16, furthermore comprising means for storing electrical power (MSTK), electrically coupled to the said electrically conducting output means.

18. Integrated structure according to Claim 15, 16 or 17, in which the interposer comprises at least one metallization level on top of a semiconductor substrate and at least a part of the electrical links between the thermocouples comprises metal tracks running over at least one metallization level.
